# EUROPEAN PATENT APPLICATION

(11) **EP 1 367 725 A1**
(43) Date of publication of application: **03.12.2003**
(21) Application number: 02077070.7
(22) Date of filing: 27.05.2002
(51) Int. Cl.: H03M 7/30

(54) **Method and apparatus for lossless (de)coding**

(71) Applicant: FrontEnd B.V., 2629 HT Delft (NL)
(72) Inventor: van 't Hart, Hubertus Gerardus Theodorus, 2623 PG Delft (NL); de Vries-Wennink, Sophia Helena Maria, 2543 LG Den Haag (NL)
(74) Representative: Prins, Adrianus Willem

(57) **Abstract**

Method and apparatus for lossless (de)coding a series n bits, with n = 1...m and n = an integer, comprising the steps of:
- dividing the series of bits in a number of bit groups with p bits with p < m: p = 1...q and p = an integer;
- coding predetermined bit groups by a first binary digit and other predetermined bit groups by a second binary digit;
- storing the resulting series of first and second binary digits;
- for each of the other predetermined bit groups subtracting for each value of p in a group the (p+1)^{th} bit from the p^{th} bit and replacing the value of each p^{th} bit for p = 1...(q-1) by the result of this subtraction in order to reduce the number of bits of each bit group by one;
- storing the reduced series of bit groups and the predetermined bit groups as a new series of bits.

## Description

The invention relates to a method and apparatus for (de)coding a series of n bits, with n = 1...m and n = an integer, and in particular to a method and apparatus by which the bits are coded in such a manner that decoding is possible without any loss of information.

The invention, for example, is applicable for coding binary data related to music or pictures, such as motion pictures.

Lossless coding methods already have been proposed. Examples are Huffman coding, Runlength coding, etc. The coding efficiency of these methods, however, is not sufficient to code, for example, a motion picture efficiently. The invention has for its object to provide a coding method by which a very high coding efficiency can be obtained. If desired, the method according to the invention can be combined with for example, the Huffman coding method, before, after or during the method according to the invention.

The method according to the invention, in accordance to a first aspect thereof, is characterized by the following steps:
- dividing the series of bits in a number of bit groups with p bits with p < m: p = 1...q and p = an integer;
- coding predetermined bit groups by a first binary digit and other predetermined bit groups by a second binary digit;
- storing the resulting series of first and second binary digits;
- for each of the other predetermined bit groups subtracting for each value of p in a group the (p+1)^{th} bit from the p^{th} bit and replacing the value of each p^{th} bit for p = 1...(q-1) by the result of this subtraction in order to reduce the number of bits of each bit group by one;
- storing the reduced series of bit groups and the predetermined bit groups as a new series of bits.

According to a second aspect of the invention the stored reduced series of bit groups is further reduced by the steps of:
- dividing the new series of bits into bit groups;
- deleting variable length bit groups having a predetermined form from the number of bit groups;
- storing the original position of these variable length bit groups in the series of bit groups;
- storing the variable length bit groups for further reduction;
- coding all remaining two-bit groups by a first binary digit and all remaining bit groups comprising three or more bits by a second binary digit;
- storing the resulting series of first and second binary digits;
- deleting all two-bit groups from the series of bit groups;
- deleting the first and last binary digit of predetermined three-bit groups;
- deleting the first binary digit of each of all the remaining bit groups;
- storing the reduced series of bit groups.
Preferably the previous steps are repeated until no further reduction is obtained.

According to a third aspect of the invention the stored variable length bit groups are further reduced by the steps of:
- coding predetermined variable bit groups by a first binary digit and all other variable bit groups by a second binary digit;
- storing the resulting series of first and second binary digits;
- deleting the first and last binary digit of predetermined variable length bit groups;
- deleting the last two binary digits from the other variable length bit groups. Preferably the previous steps according to the second and third aspect are repeated until no further reduction is obtained.

According to a fourth aspect of the invention the resulting data are further reduced by the steps of:
- forming a new series of bits from the results of the previous reduction steps in combination with all stored first and second binary digits resulting from the coding and information about the number of times a series of consecutive steps is repeated;
- repeating the previous steps until no further reduction is obtained.

The invention also relates to a method for decoding, wherein the method of the first and/or second and/or third and/or fourth aspect of the invention is applied in the opposite direction, starting from the last step and going back onto the first step in order to regain the original series of bits.

An essential aspect of the invention is the so-called positive delta coding method, by which in a series of p binary data with p = 1...q and p = an integer, the number of data is reduced by one by subtracting each bit from its immediately preceding bit, for example, bit two from bit one, or bit p from bit n-1 and forming a new series consisting of this subtraction results.

In the following the invention shall be explained on the basis of an exemplary embodiment and flow charts.

The drawings show:
Figures 1a-s: an example of a series of 88 bits, which by means of the steps according to the flow chart of the Figures 2-5 are reduced into a key code;
Figure 2: a flow chart showing the coding method according to a first aspect of the invention;
Figure 3: a flow chart showing the coding method according to a second aspect of the invention;
Figure 4: a flow chart showing the coding method according to a third aspect of the invention;
Figure 5: a flow chart showing the coding method according to a fourth aspect of the invention.
Figure 6: a block scheme of a (de)coder for executing the method of the invention.

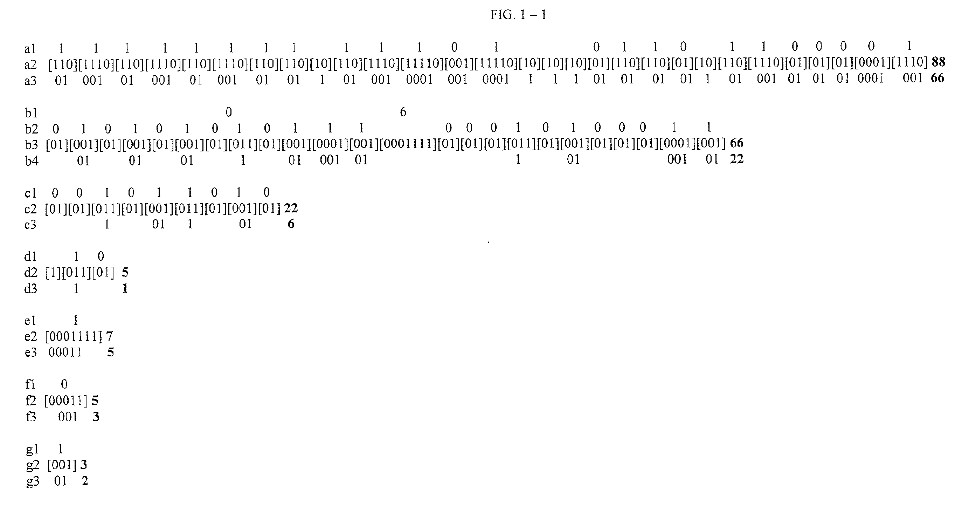

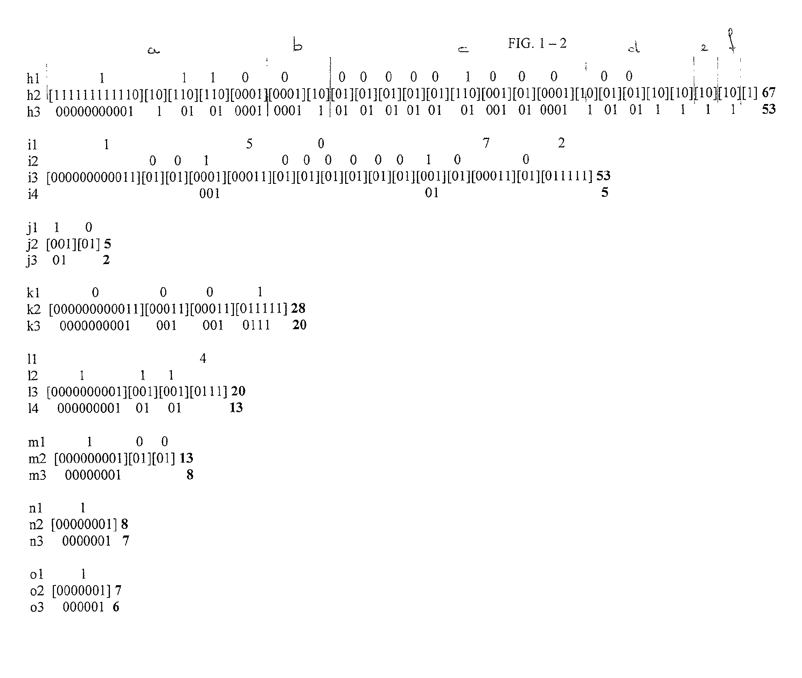

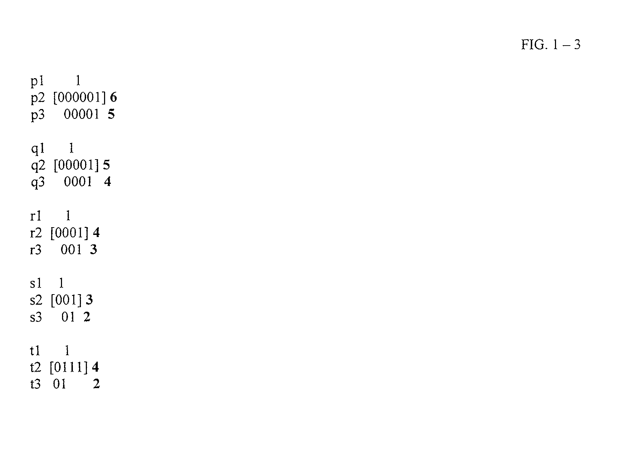

It is emphasized that the series of 88 bits shown in Figure 1 only is chosen for explaining the idea underlying the invention. The invention can be applied to each series of bits without a limitation to the length of the series or the values of the bits in the series. In general the series of bits in any case will be much longer than 88 bits, for example, at least a number of megabits.

In Figure 1, the Figure 1a shows the method according to the first aspect of the invention; the Figures 1b-d the method according to the second aspect of the invention; the Figures 1e-g the method according to the third aspect of the invention and the Figures 1h-s the method according to the fourth aspect of the invention.

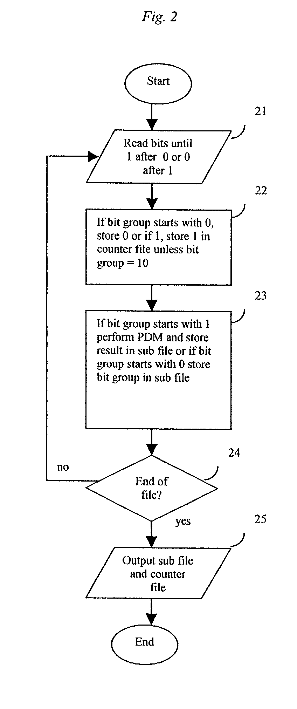

Figure 1a2 shows the original series of 88 bits, which is divided into bit groups, indicated by brackets [ ], according to the method shown in Figure 2. As shown in step 21 of Figure 2, in the series of bits each time the bits are read until a "1" is read after a "0" or a "0" is read after a "1". When this is true, this "1" or "0" defines the end of a bit group. As soon as the end of a bit group is defined, the contents of this bit group are analysed in step 22. If the bit group has a "0" as the first bit, a single bit "0" is stored in a first counter file. If the bit group has a "1" as the first bit, a single bit "1" is stored in the same counter file except when such a bit group only contains two bits [1, 0], such a [1, 0] bit group is not represented in the first counter file. Figure 1a1 shows the bits in the counter file according to step 22.

Then the basic principle of the invention is applied; the so-called positive delta method or PDM. According to PDM in a bit group of p bits with p = 1...q and p = an integer for each value of p < q, the value of bit p+1 is subtracted from the value of bit p and the result is stored. By applying this method the length of the bit group is reduced to q-1. When PDM only is applied to bit groups starting with a "1", negative results are prevented.

Step 23 of Figure 2 shows this principle when PDM only is applied to bit groups starting with a "1" and bit groups starting with a "0" are left as they are. Figure 1a3 shows the result of step 23, wherein bit groups shown in Figure 1a2 starting with a "1" are reduced by 1 bit and stored in a bit group sub file. Bit groups starting with a "0" are copied into this bit group sub file.

In step 24 of Figure 2 it is determined whether all bits of the series of bits have been treated and, if so, the output of the bit groups sub file, Figure 1a3, and of the first counter file, Figure 1a1, respectively, are outputted in accordance with step 25. If not, the steps 21-23 are repeated.

By the method of Figures 1a and 2 an efficient organisation of the series of bits into bit groups is obtained, but the number of bits necessary to represent the counter file as well as the bit groups in the sub file is larger than the original number of bits, being 88. The number of bits of Figure 1a3 is reduced to 66, the number of bits in the counter file shown in Figure 1a1 is 24. The number of bits necessary to reconstruct the series of Figure 1a2 therefore has increased from 88 to 90 bits.

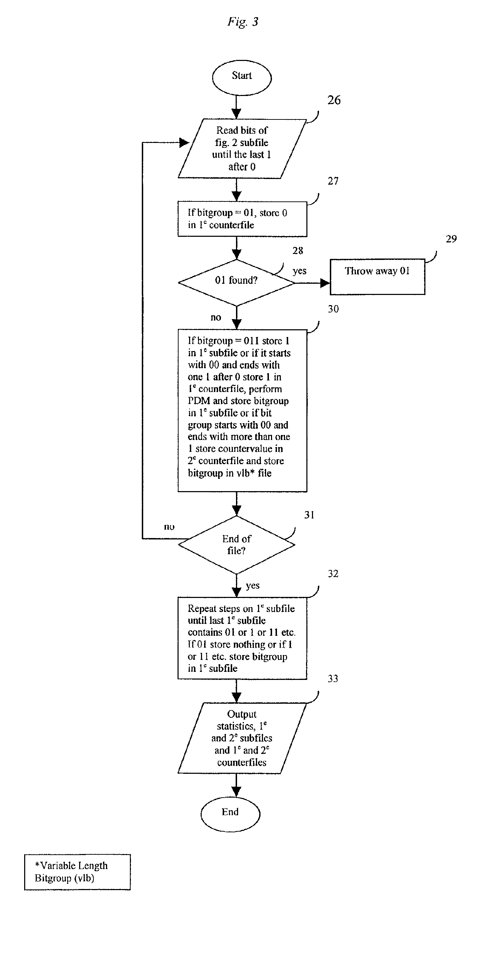

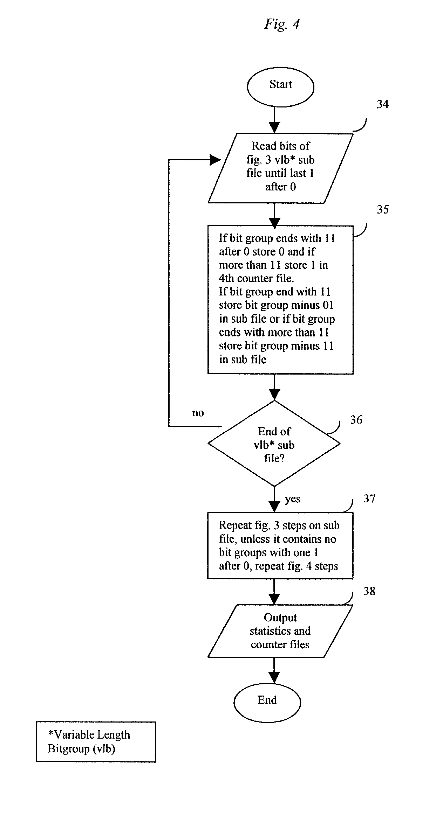

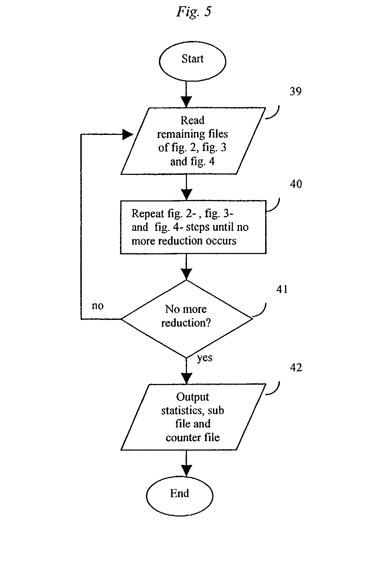

Figure 3 shows the steps according to the second aspect of the invention in which advantageously use is made of the organisation of bit groups as obtained by the method of Figure 2. The results of the method of Figure 3 are shown in Figures 1b, c and d. In step 26 the bits of the bit group of the PDM method according to Figure 2 as shown in Figure 1b3 is read bit-by-bit. The end of a bit group is defined in step 26 by each time detecting the last occurrence of a "1" after a "0". These bit groups are shown in Figure 1b3 between brackets [ ].

On each bit group of these series of bit groups the steps 27-30 are applied. When the bit group is "01" a "0" is stored in a second counter file, the contents of which are shown in Figure 1b2, and this bit group "01" is deleted in step 29. When the bit group is "011" a "1" is stored in the second counter file and a "1" is stored in a second sub file, the contents of which are shown in Figure 1b4. When the bit group starts with "00" and ends with one "1" after a "0" a "1" is stored in the second counter file and the bit group without its first "0" is stored in the second sub file.

When the bit group starts with "00" and ends with more than one "1" it forms a so-called variable length bit group. A third counter file, the contents of which are shown in Figure 1b1, is provided for storing the values of a 3-bits counter. A third counter continuously counts the bit groups of Figure 1b3. When a variable length bit group [00, ..., 11] is detected in step 30, the counter value of its position is stored in the third counter file. When the counter reaches the value 7 without a [00,...,11] being detected in the previous 7 bit groups, a "0" is stored in the third counter file. This "0" is necessary to define the start of each sub series of 7 bit groups. However, when the third counter value stored for a [00, ..., 11] value in the next 7 bit groups is < the counter value in the immediately previous 7 bit groups, this "0" can be deleted, because this third counter value, which is lower than the previous counter value, immediately makes clear that a new series of 7 bit groups has been started. By deleting this "0" a further efficiency is obtained. This principle is shown in step 30 and in Figure 1b1. A variable length bit group [00, ..., 11] is stored in a variable length bit group sub file and deleted from the series of bit groups as shown in step 30 of Figure 3.

The steps 26-30 are repeated as long as there are bits in the bit group file of Figure 1b3 as is shown in step 31 of Figure 3. Figure 1b4 shows the resulting bits in the second sub file after executing the steps 27-30 on the series of bits of Figure 1a3.

In accordance with step 32, the steps 26-30 are repeated on the second sub file of Figure 1b4 as is shown in Figure 1c2. Figure 1c1 shows the further content of the second counter file and Figure 1c3 shows a new sub file. According to step 32 the sub file of Figure 1c3 is executed again by the steps 26-30 and results in the second counter contents shown in Figure 1d1 and a sub file as shown in Figure 1d2. The steps 26-30 are repeated until the last first bit group sub file contains "01" or one or more "1"'s as is shown in Figure 1d3. The single "1" at the beginning of the sub file of Figure 1d2 is a so-called frain bit, which is stored separately in the key code as will be discussed below.

The sub file of Figure 1d3 forms at step 33 an output together with the bits of the second and third counter file and the bits of the variable length bit group sub file and the statistics. The statistics are the number of times that the loop of the steps 31-35 has been applied. In the example of Figure 1 this is three times, i.e. Figures 1b, c and d.

By the method of Figures 1b, c, d and 3 the number of bits of Figure 1a3 is reduced from 66 to 1. The number of bits in the second counter files shown in Figures 1b2, 1c1 and 1d1 is 34. The number of bits in the third counter file shown in Figure 1b1 is 6. 7 bits are stored in the variable length bit group file and 1 bit is stored in the last bit group sub file. Two bits are necessary for the statistics. The number of bits necessary to reconstruct the series of Figure 1b3 therefore has decreased from 66 to 50 bits.

Figure 4 shows the steps according to the third aspect of the invention in which the contents of the variable length bit group sub file as obtained by the method of Figure 3 are further reduced. The results of this method steps of Figure 4 are shown in Figures 1e, f and g. In step 34 the bits of the variable length bit group sub file of Figure 3 is read bit-by-bit. The end of a bit group is defined in step 34 by each time detecting the occurrence of the last "1" after a "0". In fact these are the original variable length bit groups. These bit groups are shown in Figure 1e2 between brackets [ ]. In the example of only 88 bits of Figure 1a2, only one variable length bit group is present in the variable length bit group sub file. In practical cases much more variable length bit groups will be present in the variable length bit group sub file. On each one of these series of variable length bit groups, thus only one in the example, step 35 is applied. When the bit group ends with "11" after "0" a "0" is stored in a fourth counter file and this bit group is stored in a sub file while deleting the first and last binary digit. When the bit group ends with "111", "1111" or more "1"'s after a "0" a "1" is stored in the fourth counter file and this bit group is stored in the sub file while deleting the last two times "1", this result is shown in Figure 1e3.

In step 36 of Figure 4 it is determined whether all bits of the variable length bit group sub file have been treated, according to step 37. If so, the steps 26-31 of Figure 3 or the steps 34-36 of Figure 4 are repeated on the sub file of Figure 1e3 depending on its contents, as shown in Figures 1f and g. When a sub file comprises one or more bit groups with one "1" after one or more "0"'s steps 26-31 are applied, otherwise steps 34-36. In Figure If the steps 34-36 are repeated, in Figure 1g the steps 26-31. Figures 1f1 and 1g1 show the further contents of the fourth counter file and Figures 1f2 and 1f3 the series of bits from the sub file of the previous step, i.e. Figures 1e3 and 1f3, respectively. The output of the sub file of Figure 1g3 and of the fourth counter file, Figures 1e1, 1f1 and 1g1, respectively and the statistics are outputted in accordance with step 38. The statistics are the number of times that the loop of the steps 34-35 or 26-31 has been applied. In the example of Figure 1 this is three times, i.e. Figures 1e, If and 1g.

By the method of Figure 4, as clarified by Figures 1e-g, the number of bits of the variable length bit group sub file of Figure 1e2 is reduced from 7 to 1. The number of bits in the fourth counter file shown in Figures 1e1, 1f1 and 1g1 is 3. The number of bits necessary to reconstruct the series of Figure 1e2 therefore has decreased from 7 to 4 bits.

By the method shown in Figure 1a-g a reduction of about 21% is obtainable. Starting from the series of bits according to Figure 1a2: 24 additional bits have to be stored, as explained in the above. According to the steps shown in the Figures 1b-g: 6 bits have to be stored in the third counter file and 23; 9 and 2 bits have to be stored in the second counter file, respectively, and 3 bits have to be stored in the fourth counter file. Accordingly, the number of bits is reduced from 88 bits (Figure 1a2) to 67 bits. As a result of the steps of Figure 1a-g a key code is formed consisting of sections comprising: the number of times the steps 26-31 are executed; the frain bits and their locations; the end result of the steps 26-32 (Figure 1d3); the number of times the steps 26-31 or 34-36 are applied in step 37 and the end result of step 38 (Figure 1g3). With the content of the counter files combined with the content of the key code it is possible to restore the original series of 88 bits, as will be clear to a person skilled in the art.

However, a further reduction is possible by applying the steps of Figures 2-4 on the counter files resulting from steps 25 in Figure 2, 33 in Figure 3 and step 38 in Figure 4, respectively, i.e. on the series of bits shown in Figures 1a1, 1b1, 1b2, 1c1, 1d1, 1e1, 1f1 and 1g1.

Figure 5 shows the method steps to obtain this and Figures 1h-t give the results. In step 39 the bits of the various counter files and sub files outputted in step 25, 33 and 38 each are read. Figure 1h2 shows the resulting bit file of 67 bits. For the sake of clarity the series of bits in Figure 1a2 is divided in sections a-f, which correspond with the counter results of Figures 1a1; 1b1; 1b2; 1c1; 1d1; 1e1; 1f1; and 1g1, respectively. Applying step 40 results in further reduction. On the bit series of Figure 1h2 the steps of Figure 2 are applied. On the bit series of Figures 1i2 j2, l3, m2, o2, p2, q2, r2 and s2 the steps of Figure 3 are applied and on the bit series of Figures 1k2 and 1t2 the steps of Figure 4. The Figures 1h1-1t1; 1h3-1t3 and 1i4-1l4 are similar to the corresponding parts of Figures 1a-1g as will be clear to a person skilled in the art.

When steps 39-41 are applied thirteen times in total no further compression of the files can be obtained. The number of 88 bits (Figure 1a2) is reduced to the two bits of Figure 1t3. A total reduction of about 23% of the original file of 88 bits is obtainable due to the small size of the original file. For larger file sizes higher reduction percentages are obtained.

When in step 41 it is determined that no more compression is possible only the last sub file (Figure 1t3) obtained in step 42 is stored as well as the number of times that in step 40 the steps of Figures 2, 3 and 4 are repeated. These latter values form the statistics of the system. The last sub file and the statistics of step 42 form a further key code by which the original series of bits of Figure 1a2 can be reconstructed without any loss. The counter file consisting of the counter files of Figures 1h1, 1i1 and 2 and 1j1, 1k1, 1l1 and 2 and 1m1-1t1 again form a series of bits like those of Figure 1h2 that can be further reduced. If desired, also key codes can be reduced in length by the steps of the Figures 2, 3 and 4. By consequently applying the method steps of the invention, finally a reduction of over 97% is possible. The final key word, which is no longer reduced will contain also the last counter file that remains after executing the steps of the Figures 2-4 for the very last time.

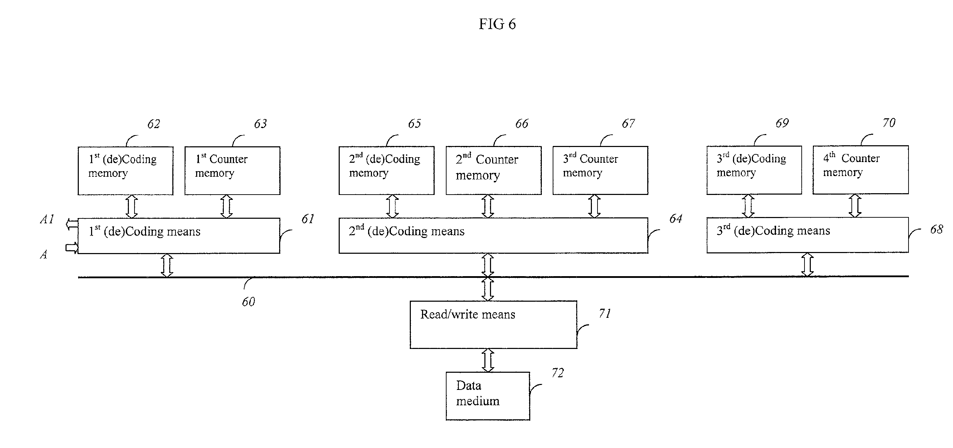

Figure 6 shows a block scheme of a (de)coder for executing the method according to the invention as described in the above. A data stream to be coded, for example the data stream of 88 bits of Figure 1a2 before it is divided in subgroups, is entered bit by bit into an input A of (de)coder 61 which is implemented to divide the stream of data into subgroups in accordance with step 21. These subgroups are stored in a first (de)coder memory 62. To each subgroup a "1" or a "0" is attributed by a first counter in (de)coder 61 in accordance with step 22, and these values are stored in a first counter memory 63. Then the (de)coder 61 applies step 31 to form the sub file shown in Figure 1a3 and this sub file is read into a second (de)coder memory 65 through a system bus 60.

The sub file stored in the second (de)coder memory 65 is read into the second (de)coder 64 in order to execute step 26, forming subgroups each starting with one or more "0's" and ending with one or more "1's". By a second one bit counter incorporated in (de)coder 64 step 27 is executed by attributing a "0" to the "01" subgroups and a "1" to all "011"subgroups and also a "1" to subgroups starting with more than one "0" and ending with one "1". The values attributed by the second counter are stored in a second counter memory 66. All subgroups to which no counter value is attributed by a second counter are detected by a third 3 bit counter that also is incorporated in decoder 64 and the counter values attributed to these subgroups, as shown in Figure 1b1, are stored in a third counter memory 67.

The second (de)coder 64 also registers the number of times that the loop formed by the steps 26-31 is executed and this number is stored in the second (de)coder memory 65. The variable length subgroups as selected by step 30, for which a counter value is stored in the third counter memory 67 are transferred to the third (de)coder memory 69 through bus 60 and stored as a series of bits.

A third decoder 68 is implemented to execute the steps 34-37 by dividing the series of bits in the third (de)coder memory into subgroups starting with one or more "0"'s and ending with one or more "1"'s in accordance with step 34.

To the thus formed bit groups counter values "1" or "0" are attributed by a fourth 1-bit counter implemented in (de)coder 68. When a bit group ends with "11" a "0" is stored and if it ends with more than two times a "1" a "1" is stored. The third (de)coder 68 executes the further reduction of step 35 and the results are stored in memory 69. The series of bits stored in memory 69 then, depending on its actual form, is executed various times by the second decoder 64 and the third decoder 68 as described in the above in connection with the Figures 1, 3 and 4. The second and third (de)coder 64, 68 register the number of times that the loop of the steps 26-31 or 34-36, respectively, is executed during this process and store these numbers in the (de)coder memory 65 or 69.

When no further reduction of the bits stored in the third memory 69 is possible a key code is formed consisting of the contents of the first, second and third (de)coder memories, as explained in the above.

The contents of the first, second and third counter memories again are applied to input A of decoder 61 and all steps are repeated and key codes formed until no further reduction of counter values is possible, as described in connection with the Figures 1f-s. The key codes can be handled in the same manner.

The key code file that results when no further reduction is possible or desired, is applied to a read/write unit 71 through bus 60. The read/write unit can write the key code on a data carrier 72, such as a hard disk, a chip card or another type of memory. For decoding, the key code is read from the data carrier by the read/write unit 71 and applied to input A1 of the first (de)coder 61 for executing all steps in reverse order in order to obtain the original data without any loss.

## Claims

1. Method for coding a series of n bits, with n = 1...m and n = an integer, **characterized by** the steps of:
- dividing the series of bits in a number of bit groups with p bits with p < m: p = 1...q and p = an integer;
- coding predetermined bit groups by a first binary digit and other predetermined bit groups by a second binary digit;
- storing the resulting series of first and second binary digits;
- for each of the other predetermined bit groups subtracting for each value of p in a group the (p+1)^{th} bit from the p^{th} bit and replacing the value of each p^{th} bit for p = 1...(q-1) by the result of this subtraction in order to reduce the number of bits of each bit group by one;
- storing the reduced series of bit groups and the predetermined bit groups as a new series of bits.

2. Method according to claim 1, wherein the series of bits is read until a first binary digit is read after a second binary digit or a second binary digit is read after a first binary digit, such a second binary digit or first binary digit respectively defining the end of a bit group.

3. Method according to claim 1 or 2, wherein the stored reduced series of bit groups is further reduced by the steps of:
- dividing the new series of bits into bit groups;
- deleting variable length bit groups having a predetermined form from the number of bit groups;
- storing the original position of these variable length bit groups in the series of bit groups;
- storing the variable length bit groups for further reduction;
- coding all remaining two-bit groups by a first binary digit and all remaining bit groups comprising three or more bits by a second binary digit;
- storing the resulting series of first and second binary digits;
- deleting all two-bit groups from the series of bit groups;
- deleting the first and last binary digit of predetermined three-bit groups;
- deleting the first binary digit of each remaining bit group;
- storing the reduced series of bit groups.

4. Method according to claim 3, wherein the stored variable length bit groups are further reduced by the steps of:
- coding predetermined variable bit groups by a first binary digit and all other variable bit groups by a second binary digit;
- storing the resulting series of first and second binary digits;
- deleting the first and last binary digit of predetermined variable length bit groups;
- deleting the last two binary digits from the other variable length bit groups.

5. Method according to claim 3 or 4, wherein the new series of bits is read until the last second binary digit after a first binary digit, this last second binary digit defining the end of a bit group.

6. Method according to any of the claims 2-5, wherein the steps are repeated until no further reduction is obtained.

7. Method according to any of the previous claims, wherein the resulting data are further reduced by the steps of:
- forming a new series of bits from the results of the previous reduction steps in combination with all stored first and second binary digits resulting from the coding and information about the number of times a series of consecutive steps is repeated;
- repeating the previous steps until no further reduction is obtained.

8. Method for decoding a key code by applying the steps of any of the claims 1-7 in reverse order.

9. Apparatus for (de)coding a series of bits comprising first (de)coding means having an input for binary data and comprising a first counter, a first (de)coding memory and a first counter memory; second (de)coding means comprising a second and a third counter, a second (de)coding memory and second and third counter memories; third decoding means comprising a fourth counter and a third (de)coding memory and a fourth counter memory, all (de)coding means being coupled to a data bus, the apparatus being implemented to carry out the method steps of any of the claims 1-8.

10. Apparatus according to claim 8, wherein a read/write apparatus is coupled to the data bus.
